(19)

Europäisches
Patentamt
European
Patent Office
Office européen
des brevets

(11) **EP 1 590 306 B1**

(12) **EUROPEAN PATENT SPECIFICATION**

(45) Date of publication and mention
of the grant of the patent:
**07.07.2010 Bulletin 2010/27**

(51) Int Cl.:
***C03C 17/245*** (2006.01)   ***C03C 17/34*** (2006.01)

(21) Application number: **04703863.3**

(22) Date of filing: **21.01.2004**

(86) International application number:
**PCT/IB2004/000133**

(87) International publication number:
**WO 2004/067464 (12.08.2004 Gazette 2004/33)**

(54) **METHOD OF PRODUCING TRANSPARENT TITANIUM OXIDE COATINGS HAVING A RUTILE STRUCTURE**

VERFAHREN ZUR HERSTELLUNG VON TRANSPARENTEN TITANOXIDBESCHICHTUNGEN MIT RUTILSTRUKTUR

PROCEDE DE PRODUCTION DE REVETEMENTS D'OXYDE DE TITANE TRANSPARENTS PRESENTANT UNE STRUCTURE DE RUTILE

(84) Designated Contracting States:
**AT BE BG CH CY CZ DE DK EE ES FI FR GB GR HU IE IT LI LU MC NL PT RO SE SI SK TR**

(30) Priority: **28.01.2003 EP 03100169**

(43) Date of publication of application:
**02.11.2005 Bulletin 2005/44**

(73) Proprietors:
• **Philips Intellectual Property & Standards GmbH 20099 Hamburg (DE)**
Designated Contracting States:
**DE**
• **Koninklijke Philips Electronics N.V. 5621 BA Eindhoven (NL)**
Designated Contracting States:
**AT BE BG CH CY CZ DK EE ES FI FR GB GR HU IE IT LI LU MC NL PT RO SE SI SK TR**

(72) Inventors:
• **RITZ, Arnd**
**52066 Aachen (DE)**
• **VERGÖHL, Michael**
**52066 Aachen (DE)**
• **HUNSCHE, Berno**
**52066 Aachen (DE)**

(74) Representative: **Volmer, Georg**
**Philips Intellectual Property & Standards GmbH**
**Postfach 50 04 42**
**52088 Aachen (DE)**

(56) References cited:
**EP-A- 0 838 535     US-A- 4 048 347**
**US-A- 5 362 552**

• **OKIMURA K ET AL: "CHARACTERISTICS OF RUTILE TIO2 FILMS PREPARED BY R.F. MAGNETRON SPUTTERING AT A LOW TEMPERATURE" THIN SOLID FILMS, ELSEVIER-SEQUOIA S.A. LAUSANNE, CH, vol. 281/282, no. 1/2, 1 August 1996 (1996-08-01), pages 427-430, XP000643433 ISSN: 0040-6090**
• **PATENT ABSTRACTS OF JAPAN vol. 0072, no. 53 (P-235), 10 November 1983 (1983-11-10) & JP 58 137809 A (FUJITSU KK), 16 August 1983 (1983-08-16)**
• **FUKUSHIMA K ET AL: "ELECTRICAL PROPERTIES OF TIO2 FILMS DEPOSITED BY A REACTIVE-IONIZEDCLUSTER BEAM" JOURNAL OF APPLIED PHYSICS, AMERICAN INSTITUTE OF PHYSICS. NEW YORK, US, vol. 65, no. 2, 15 January 1989 (1989-01-15), pages 619-623, XP000119020 ISSN: 0021-8979**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

The invention relates to a method of producing transparent titanium oxide coatings having a rutile structure, and also to articles having said coating, such as lamps, optical filter systems, in particular hot light mirrors, cold light mirrors, antireflection systems, band-pass filters, cut-off filters and low-e glazing. Articles having said coating can also be used for electrical applications, such as diffusion barriers or capacitor elements. Further applications may be beam-forming or beam-splitting devices on optical fibers or micro-optical components, for instance for selecting defined wavelength ranges or for splitting signals onto various signal paths.

It is known to provide lamps for various purposes with optical layers, that is to say to coat them. Depending on the principle of action, the complete bulb of the lamp may be covered, such as that of the known halogen energy-saving lamp having an infrared reflective coating. However, it may be necessary to cover only a precisely defined part of the lamp surface, such as in the case of headlight mirror lamps for example.

On account of the high degree of flexibility in the spectral action, multilayer interference filters are often used for the optical layers. Such multilayer interference filters consist of stacks of at least two different dielectric materials having different refractive indices. The transmission and reflection ranges of these filters are determined by the layer thicknesses of the individual layers which are made up alternately of highly refractive and weakly refractive material. Such filters may be composed of one single layer, as in the case of a very simple antireflection coating, or may be composed of several hundred layers, as in the case of a multiplexer in optical communication.

The difference in refractive index of the materials used is of particular importance for the design of such filter stacks. In general, a predefined spectral target function can be implemented better the greater this difference in refractive index. With a large difference in refractive index, for example, the number of layers in the design and the overall thickness are smaller, and this generally also leads to better production of the filters.

Besides these optical considerations, thermo-mechanical features such as phase conversions in the use temperature range and the thermal expansion coefficient of the materials compared with the substrate are of great importance for the ability of products to be produced and used.

For optical layers on lamps, in particular for lamps with a quartz bulb, $SiO_2$ is usually used for the weakly refractive layers on account of the almost perfect matching in terms of the thermal expansion coefficient to the wall material of the lamp and on account of the low refractive index.

For the highly refractive layers, as is known, a large number of materials can be used. Examples include $Ta_2O_5$, $S_{13}N_4$ and $Nb_2O_5$. A particularly suitable material in this connection is $TiO_2$, which has the highest refractive index of the abovementioned materials. $TiO_2$ has, inter alia, a low temperature modification, anatase, which is stable up to around 650°C, and a high temperature modification, rutile, which is stable in the adjacent temperature range. Rutile has the considerably higher refractive index.

In optical coatings, in which modification and with which refractive index the $TiO_2$ exists depends on the production conditions and on the subsequent treatment. Mixtures of both modifications are also possible.

In the current layer production method, after deposition $TiO_2$ exists as anatase, that is to say as the more weakly refractive of the two materials. The transition to the more highly refractive high temperature phase, rutile, can be achieved by annealing above the transition temperature, either by a dedicated process step or simply by operating the lamp if the operating temperature is sufficiently high, as in the case of high-wattage HID burners.

However, this phase transition results in a particular disadvantage. This phase transition changeover is associated with changes in the lattice properties, so that the density of the material increases by about 10%. Accordingly, the layers must shrink geometrically, and this leads to layer stresses. These cause tears to arise in the filter, particularly in the case of relatively thick layer stacks having an overall thickness of more than about 1 $\mu$m, and these tears may lead to the filter being destroyed and thus to a considerable shortening of the life of the lamps.

The result is that the structure of $TiO_2$ which is more interesting in optical terms and in terms of solid-state physics, namely rutile, is epitaxially grown only at very high temperatures. This has the disadvantage that on the one hand a complex thermal process must be used to generate and stabilize this phase of the $TiO_2$; on the other hand, certain lamps are operated at very high temperatures, so that the rutile forms by itself as a phase of the $TiO_2$ on account of the high operating temperature of the lamp. However, this has the serious disadvantage that the "subsequent" phase transition in multilayer systems leads to crystallographic stress, which can tear the thin layers as described above. A phase transition or a change of the material properties may lead to a failure of the component, e.g. by changing the refractive index and/or the layer thickness.

On the other hand, the known method also has another drawback, namely that a substrate which cannot withstand heat treatments at 600°C and above cannot be coated with the desired coating of rutile. Many plastics are thermally stable, for example, only up to a maximum temperature of 150°C.

It is thus an object of the invention to develop a coating and a method of the abovementioned type such that the coating with rutile is considerably simplified and that it is possible to carry out the coating at lower process temperatures.

This object is achieved as claimed in claim 1 by a transparent, thermally stable coating comprising titanium oxide and having a rutile structure, having at a wavelength of 550 nm a refractive index of n = 2.65 to n = 2.75 and being produced, at an oxygen partial pressure p which can be defined, by high ion bombardment sputtering at an initial deposition temperature of 100 to 200 °C from a titanium target with an ion sputtering power density of 9 - 15 W/cm$^2$ and especially preferably 11 - 12 W/cm$^2$. - . Preferably, after annealing in a furnace at 800°C for 15 hours, the coating remains transparent and/or has a refractive index of n = 2.65 to n = 2.75.

Further suitable values for n are 2.73; 2.71; 2.69 and 2.67.

The layer or coating according to the invention is substantially amorphous, preferably is amorphous, and has a rutile-like short-range order structure, with the layer preferably not having any anatase structure or having practically no anatase structure.

A further subject matter of the present invention relates to a multilayer interference filter for reflecting light within a wavelength range of the transparent spectrum of 250 nm to 5000 nm, in particular 380 to 3000 nm, preferably 350 to 2500 nm, more preferably 400 to 2000 nm and even more preferably 420 to 1500 nm, with the layer having one or more first layers according to the invention and one or more second layers with a refractive index which is lower than that of the one or more first layers according to the invention, said layers being arranged alternately on a substrate, preferably a transparent substrate. Further suitable reflection ranges are 680 to 2600 nm, 800 to 2500 nm, 820 to 2450 nm and 850 to 2400 nm, with ranges of 1000 - 1900 nm and 1050 - 1800 nm being particularly preferred.

The multilayer interference filter may, at a wavelength of λ = 550 nm, for the one or more second layers have a refractive index of n = 1.32 to n = 2.0, preferably n = 1.35 to n = 1.80 and more preferably n = 1.44 to n = 1.75. Further suitable values for n are 1.40; 1.42; 1.46; 1.48 and 1.50. By way of example, the refractive index may be n = 1.45 for an SiO$_2$ layer.

Yet another subject matter of the present invention relates to a method of producing the coating or layer, in which, in order to produce the transparent, thermally stable coating comprising titanium oxide, the coating comprising titanium oxide is deposited, with the rutile structure being obtained, on the surface of the substrate that is to be coated, at an oxygen partial pressure p which can be defined, by high ion bombardment sputtering, at an initial deposition temperature of the substrate of 100 to 200°C from a titanium target with an ion sputtering power density of 9 - 15 W/cm$^2$ and especially preferably 11 - 12 W/cm$^2$.

Reactive magnetron sputtering, ion beam sputtering, ion- or plasma-assisted sputtering and also other sputtering methods known to the person skilled in the art, for example harmonically excited reactive double magnetron sputtering methods and medium-frequency double magnetron processes, can be used for high ion bombardment sputtering.

Such one or more layers according to the invention can be used to coat light means, such as lamps, suitable for illumination purposes, in particular in motor vehicles.

The titanium target that can be used according to the invention is preferably made of pure titanium. The sputtering of mixed oxide layers is possible both from 2 different metal targets, from one or more metal alloy targets and also from ceramic oxide targets. In general, the operation is carried out in an oxygen/argon atmosphere.

The statements made in the following paragraphs relate in each case only to the highly refractive layers of the interference stack. In the interference stacks, the ratio of highly refractive material to weakly refractive material depends on the design of the filter. According to the invention, however, all filters can be used which comprise more than 2 layer materials, for example at least 2 different highly refractive materials.

The rutile fraction of the coating should be at least 75% by weight, preferably > 80% by weight, more preferably > 85% by weight, even more preferably > 90% by weight and most preferably 95% by weight - 100% by weight based on the overall weight of this coating.

The titanium dioxide fraction of the coating should be at least 50% by weight, preferably > 60% by weight, more preferably > 70% by weight, even more preferably > 80% by weight, particularly preferably > 90% by weight and most preferably 95% by weight-100% by weight based on the overall weight of this coating.

Titanium oxide, referred to in the description as TiO$_2$, may also within the context of the invention mean TiO$_x$, where x = 1.9 to 2.1.

Further advantageous embodiments of the subject matter of the present invention are specified in the subclaims.

In this way, the rutile phase or the rutile structure can be produced at a much lower temperature than in known methods. This furthermore has the advantage that substrates which cannot be heated above 200°C can now be coated with the optically very valuable rutile. As described above, rutile has a very high refractive index.

The subject matter of the invention illustrated herein is that of making rutile usable without requiring a treatment at high temperature and while circumventing the abovementioned stability problems. For this, the invention is aimed at producing layers directly during the coating in the rutile structure and with a high refractive index.

The refractive index of the transparent coating according to the invention, at a wavelength of 550 nm has n = 2.65 to n = 2.75.

Preferably, after annealing in a furnace at 800°C for 15 hours, the coating remains transparent and/or has a refractive index of n = 2.65 to n = 2.75.

Unless specified otherwise, measurements have been taken at room temperature, that is to say 23°C.

Dedicated studies have shown that the purpose of the invention can be achieved by suitably selecting the process parameters during the production of the layers. As illustrated in more detail in the example of embodiment, a coating with rutile structure and accordingly high refractive index can be obtained at initial deposition temperatures of between, for example, 100°C and 200°C and with simultaneous targeted ion bombardment of the epitaxially growing layer.

Initial deposition temperatures at the start of the process which are preferred according to the invention are 100°C - 200°C, preferably 110 - 190°C, even more preferably 120°C - 180°C, yet more preferably 130°C - 170°C and particularly preferably 140°C - 160°C.

The substrate that is to be coated is heated to a temperature of 100°C-200°C before it is coated. The substrate is preferably transparent. However, the substrate may also not be transparent, for example a non-transparent wafer.

The insertion or application of the layers according to the invention into or onto articles, such as lamps, glasses, in particular insulation glazing, plastics, gas sensors, optical interference filters, optical filter systems, in particular hot light mirrors, cold light mirrors, laser mirrors, antireflection systems, band-pass filters, cut-off filters, low-e glazing and/or onto articles for electrical applications, such as electrical components, diffusion barriers or capacitor elements or lamps or components of optical information technology opens up the possibility of achieving the very high refractive index of rutile and thus associated effective and cost-saving designs. This advantage also becomes possible for products or substrates which cannot withstand a heat treatment above 200°C. Furthermore, when using the material demonstrated here in lamps with high operating temperatures, the phase transition from anatase to rutile and the associated problems for the life of the lamp do not occur.

Articles with said coating can be selected from the group comprising light means, in particular lamps, preferably suitable for use in motor vehicles, lamp housings, gas sensors, glasses, in particular insulation glazing, plastics, transparent elements, filters, lenses, mirrors, laser mirrors, in particular transparent filter systems, hot light mirrors, cold light mirrors, antireflection systems, band-pass filters, cut-off filters, low-e glazing and/or articles for electrical applications, such as electrical components, in particular diffusion barriers and/or capacitor elements.

In another advantageous refinement, it is specified that, at the chosen temperatures, the crystallization of $TiO_2$ to the anatase phase is purposefully avoided or considerably reduced by the setting of a suitable sputtering power density and by the ion bombardment on the epitaxially growing layer.

The sputtering power density is defined as the coupled-in process power standardized to the target area used.

Furthermore, it is advantageous that the sputtering power density and/or the temperature is varied such that, under the process conditions which can then be reproduced and the nature of the substrate, the anatase phase is purposefully avoided or considerably reduced, in favor of a predominantly amorphous and particularly preferably completely amorphous rutile short-range order phase structure.

To achieve a coating having a, preferably pure, rutile phase, the sputtering power density is 9 - 15 $W/cm^2$ and particularly preferably 11 - 12 $W/cm^2$.

Advantageously, the set oxygen partial pressure is $p \leq 100$ mPa. Oxygen partial pressures that are suitable according to the invention may be 6 - 10 mPa and particularly preferably $\leq 8$ mPa. Further oxygen partial pressures that are suitable according to the invention are 3 - 40 mPa, 4 - 20 mPa and particularly preferably 5 - 12 mPa.

For the effective oxidation of the sputtered titanium, it is provided that the oxygen partial pressure in the sputtering device is $p \leq 100$ mPa, preferably is set to $2mPa \leq p \leq 15mPa$.

To increase and set an optimal reproducibility, it is provided that, in a manufacturing process, the layers produced are controlled, at least in a randomly sampled manner, in terms of reproducibility of the structure and layer thickness, in particular by means of Raman spectroscopy.

As an alternative or in addition to this, in a manufacturing process, these layers produced are controlled, at least in a randomly sampled manner, in terms of reproducibility of the structure and layer thickness, also by means of X-ray spectroscopy.

Layer thicknesses that are suitable according to the invention are 50 nm to 20 $\mu$m, preferably 75 nm to 8 $\mu$m, frequently 100 nm to 4 $\mu$m and also frequently 300 nm to 3 $\mu$m.

In an advantageous refinement, it is specified that the process parameters can where necessary be adapted using the measurement results obtained by the control measurements. In this way, the control measurements serve not only to control a product for the purpose of quality assurance, but also to adjust the parameters on the basis of the measurement results in order to optimize the manufacturing outcome.

An essential step consists in the spectrometric fractions between anatase and rutile being determined during the Raman spectroscopy and the process parameters being changed such that rutile is predominantly or exclusively generated. In this way, it is possible for there to be a concentration of rutile instead of anatase that can be reproduced using manufacturing technology.

In another advantageous refinement, it is now possible that the spectroscopic results are evaluated automatically and the process parameter changes that are thereupon generated automatically are stored in an adaptive manner and optimized from measurement to measurement. There are thus optimal parameters which renew themselves in a self-leaming manner for an optimal manufacturing outcome.

There are now various applications for this. One of these is the coating of lamp housings in this way. Lamp housings within the context of this invention include, in particular, lamp housings which are evacuated or filled with ionizable material.

Another application is the coating of optical elements, such as filters, lenses, mirrors, fiber-optic components and the like in this way.

With regard to a lamp or a light means, the subject matter of the invention is that the lamp vessel is at least partially provided with a rutile coating which is deposited onto the surface that is to be coated at an oxygen partial pressure p by means of sputtering at an initial deposition temperature of 100 to 200°C from a titanium target.

With regard to a coating on optical elements such as filters, lenses and mirrors, the subject matter of the invention is that the optical element is at least partially provided with a rutile coating which is deposited onto the surface that is to be coated at an oxygen partial pressure p by means of sputtering at an initial deposition temperature of 100 to 200°C from a titanium target.

Advantageously, a multilayer system is applied, at least one layer of which consists predominantly of rutile.

Multilayer coatings have particular optical properties. For instance, multilayer coatings as such are also known, but in the present case the example of embodiment deals with the provision of at least one layer composed of rutile, which in the abovementioned method is applied to the surfaces gently and at relatively low temperatures.

The quality and above all the monitoring of the process is ensured by the fact that the layers produced can be controlled in a manufacturing process, at least in a randomly sampled manner, in terms of reproducibility of the structure and layer thickness, by means of Raman spectroscopy.

As an alternative or in addition to this, it is also possible for the layers produced to be controlled in a manufacturing process, at least in a randomly sampled manner, in terms of reproducibility of the structure and layer thickness, by means of X-ray spectroscopy.

In another advantageous refinement it is provided that the process parameters can where necessary be adapted or automatically adapted using the measurement results obtained.

In both cases, the measured outputs of the measuring devices are linked by information technology to the control of the sputtering system.

Furthermore, it is specified that the spectrometric fractions between anatase and rutile are determined during the Raman spectroscopy and the process parameters are changed such that rutile is predominantly or exclusively generated. In this way, automatic evaluation of Raman spectra may also provide, where necessary, automatic setting of the process parameters for the optimized generation of rutile.

In another advantageous refinement, therefore, it is provided that the spectroscopic results are evaluated automatically and the process parameter changes that are thereupon generated automatically are stored in an adaptive manner and optimized from measurement to measurement.

With regard to a software program product, the subject matter of the invention is that, in a software program product in which the functions and control parameters of the production process for lamps or lights or coatings are stored as control commands of a device on a removable storage medium or in a data-network-enabled data file, and thus can be imported into or exported from the control unit of a sputtering device as control parameters having the specified functions.

The scattering index, also referred to as iHaze, of the transparent titanium dioxide layer according to the invention, after annealing in a furnace at 800°C for 15 hours, for the still-transparent layer having a layer thickness of 400 nm, has a spectrally integrated Haze ("iHaze") of $\geq$ 0 nm to 80 nm, preferably an iHaze value of 20 nm to 70 nm, more preferably an iHaze value of 30 nm to 60 nm and even more preferably an iHaze value of 40 nm to 50 nm. An optimal layer has no scattering and thus has an iHaze = 0 nm. iHaze values of $\geq$ 0 nm are therefore most preferred. Further suitable iHaze values are $\geq$ 1 nm, $\geq$ 10 nm and $\geq$ 15 nm. It should be emphasized that an iHaze value that is as small as possible, from 0 nm to 1 nm, is most preferred.

The titanium dioxide layer according to the invention remains transparent after annealing in a furnace at 800°C for 15 hours under an ambient air atmosphere.

The invention will be further described with reference to examples of embodiments shown in the drawings to which, however, the invention is not restricted.

Fig. 1 shows the design of a sputtering device.
Fig. 2a shows the refractive index of titanium dioxide.
Fig. 2b shows the result with a higher degree of roughness.
Fig. 3a shows the XRD spectrum.
Fig. 3b shows the Raman spectrum.
Fig. 4 shows the Raman spectrum.

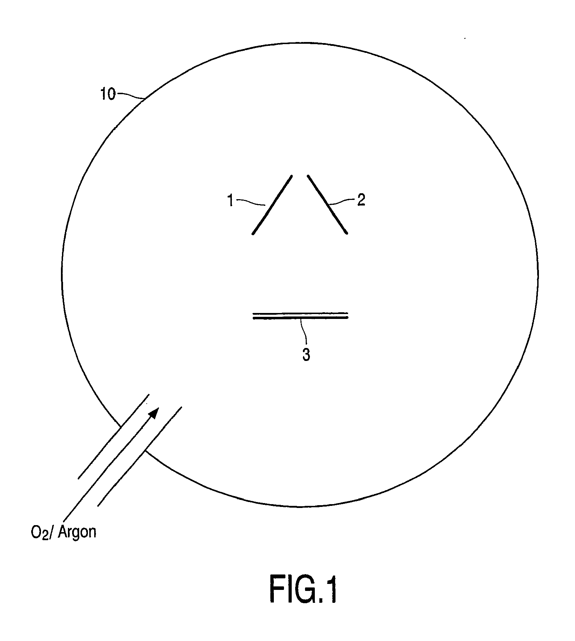

Fig. 1 shows a design, in principle, of a sputtering system 10. Highly refractive titanium dioxide layers are produced at an excitation frequency of f = 40 kHz using a harmonically excited reactive double magnetron sputtering method. Two metal magnetron targets. 1, 2 made of titanium, having dimensions of 488 mm x 88 mm and being placed edgeways at an angle of 20° to one another, are simultaneously worn down by the method used. The period duration per target is in each case 25 $\mu$s. By means of the controlled addition of oxygen as reactive gas, transparent oxidic films form on the substrate 3 shown here. The oxygen partial pressure (p) is $p_{02}$ = 8 mPa and the overall pressure is 150 mPa. The coupled-in process power was in the range of 5 to 5.5 kW. The deposited layer thicknesses were about $d_f$= 400 nm. The dimensions of the quartz glass substrate used were 50 x 50 mm. Instead of the planar substrate shown here, lamp vessels or light housings may also be provided as substrate, which are then coated accordingly.

The grounded substrate holder is at a distance of 90 mm from the targets. The horizontal component of the magnetic field across the magnetron at the location of the substrate 3 is about 30 mT. The temperature of a flat heater element fitted behind the substrate 3 is controlled to a defined temperature by means of a PID controller. In this case, the heater is switched on 30 minutes before the start of the process and left on during the coating operation. Besides the heater, the specimen is additionally heated by the action of the plasma during the coating process.

The operating points used for coating were in the so-called "transition mode". This parameter range, which is usually unstable, is characterized by only partially oxidized targets and also high coating rates. In terms of process technology, it can only be accessed using specific control methods. In the present case, the oxygen partial pressure is controlled via the adapting of the process power and measured using a specifically modified lambda probe.

The layers are optically characterized, for example, by means of ellipsometry. Crystallographic and morphological studies are carried out using Raman and X-ray scattering measurements.

The process conditions used promote the epitaxial growth of very thick, smooth and optically very valuable amorphous layers. The reason for this lies, in particular, in the particularly high ion bombardment that is typical for medium-frequency double magnetron processes. Other coating parameters that are highly relevant in particular for the growth of titanium dioxide are the oxygen partial pressure and the coating temperature.

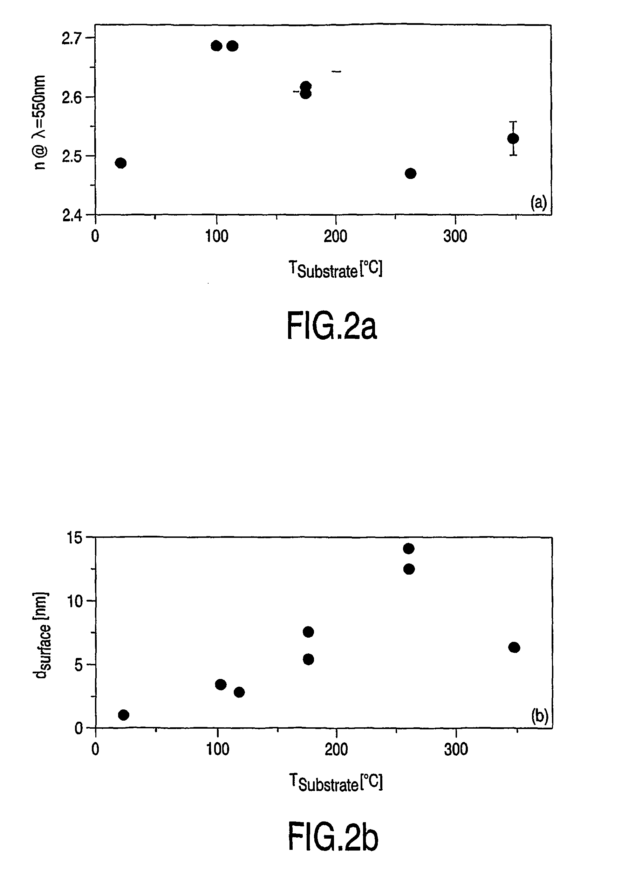

Fig. 2a shows, as an important optical parameter, the refractive index of titanium dioxide at a wavelength of $\lambda$ = 550 nm as a function of the substrate temperature, brought about by the heater, at the start of the process. It can be seen that at a substrate temperature at the start of the process of about $T_s$ =130°C, a maximum of $n_{550nm}$ = 2.7 will pass through in a reproducible manner. In processes without a heating action, typical values of about $n_{550nm}$ = 2.5 arise. At values of $T_s$ > about 200°C, the refractive index decreases again significantly and at the same time it is only possible to measure the layers more roughly, as can be seen from the values shown in Fig. 2b. Both the decrease in the refractive index and the increase in roughness are caused by the thermally induced growth of the anatase phase.

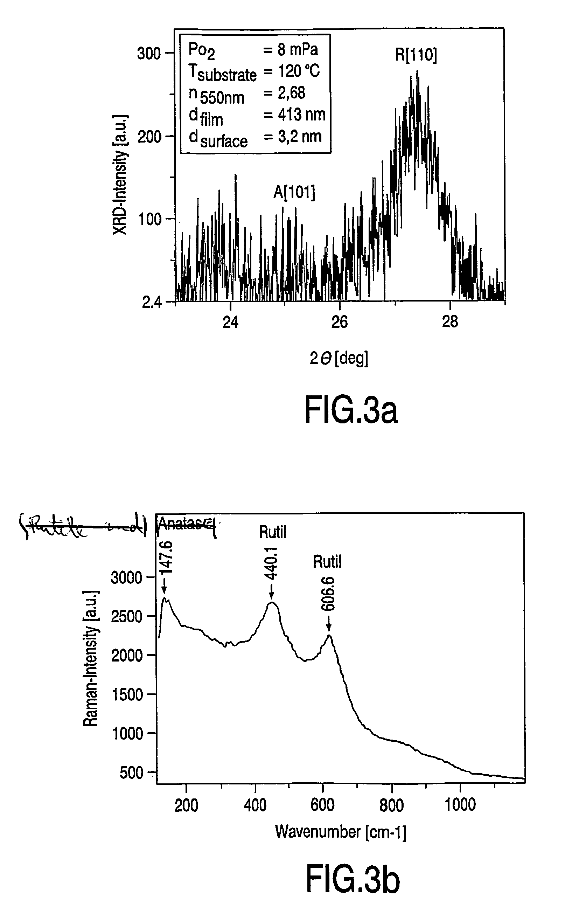

Fig. 3 shows the XRD and Raman spectra of the highly refractive specimen produced at a substrate temperature at the start of the process of $T_s$ = 120°C. The only peak which can be detected in the entire X-ray spectrum is a rutile (110) peak which allows a practically amorphous structure with small embedded rutile crystals to be deduced. The results of the Raman measurement show an equivalent image. Besides a weakly pronounced structure at about $\chi$ =148 cm$^{-1}$ that can be assigned to both the rutile and the anatase phase, clear peaks that can be attributed to the rutile short-range order can be seen.

According to the invention, therefore, by selecting the coating parameters an operating point is defined at which the growth of the anatase phase is not yet possible in terms of the thermal conditions, and in particular is suppressed by the high ion bombardment. The highly refractive layers for a substrate temperature at the start of the process of $T_s$ = 100 to 200°C have an amorphous or nanocrystalline structure characterized by a rutile short-range order, which for its part is promoted by the intense ion bombardment. By contrast with the anatase phase, the rutile phase has, in addition to a higher density, also a considerably higher refractive index.

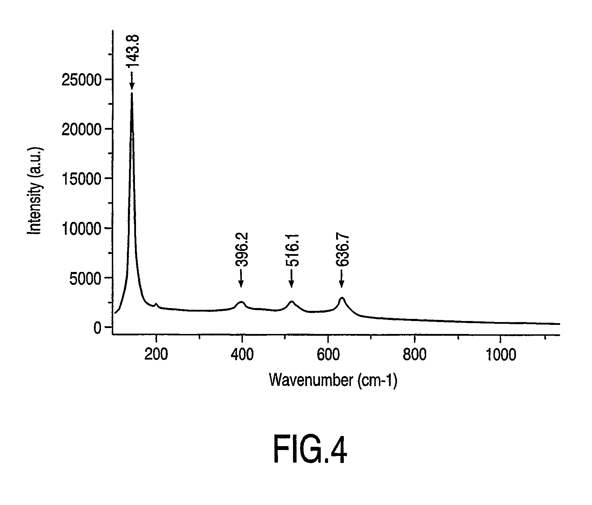

In comparison with Fig. 3b, Fig. 4 shows the Raman spectrum of a $TiO_2$ specimen which has been produced at a substrate temperature at the start of the process of $T_s$ = 130°C and with a considerably lower ion bombardment using a cocurrent sputtering process. All peaks can unambiguously be assigned to the anatase phase.

General details regarding the measurement conditions

    *T* = 23°C *(ambient temperature)*
    *Atmospheric pressure = laboratory air (normal pressure)*

• Annealing operation

Annealing in the laboratory air at normal pressure. Annealing duration: in each case 15 hours.

• X-ray diffractometry

In order to be able to make statements regarding phase compositions and particle sizes, X-ray diffractometric measurements were taken using a *D5000* diffractometer from *Siemens.* In this case, a Bragg-Brentano geometry without monochromator was used in the (θ-2θ) method. An Ni filter suppressed the $CuK_\beta$ line which arose.

A Cu-$K_\alpha$ tube was used as radiation source. Typical measurement parameters were: step size: $2\theta = 0.02°$, integration time: $\Delta t = 1$ s. The beam potential was 40 kV at a beam current of 30 mA. Software from Siemens that was integrated in the measurement software was used for phase assignment.

• Haze

The quantification of the scattering level of the specimens is based on the determination of a parameter which is referred to as "Haze". In this measurement method, the diffusely scattered component of the transmitted electromagnetic radiation is determined using a spectral photometer and standardized to the overall transmitted intensity ($T_{total} = T_{spec} + T_{diffus}$). The Haze in transmission is therefore defined in a range of values between zero and one as

$$Haze(\lambda) = \frac{T_{diffus}(\lambda)}{T_{total}(\lambda)} = \frac{T_{diffus}(\lambda)}{T_{diffus}(\lambda) + T_{spec}(\lambda)} \qquad (1)$$

It should be noted that the measurement curves generally contain intensity modulations on account of interference effects, and these cannot be fully compensated for by means of the standardization. However, their influence can be substantially suppressed by measuring over a broad spectral range.

Using suitable mathematical methods, the respective scattering level of the specimen can be quantified from the data of the spectral measurements. In the present work, the area below the curve in the visible spectral range ($\lambda = 380...800$ nm) is for this purpose integrated ("iHaze") according to equation (2), so that the intensity modulations average out. Since the layer thicknesses of all specimens were set to be about $400 \pm 10$ nm, there is no need to consider any thickening effect of the scattering. The scattering contribution of the glass substrate on account of any inhomogeneities or incomplete surface cleaning can also be ignored in this evaluation since it falls within the order of magnitude of the measurement accuracy. By means of the spectral integration of the dimensionless parameter "Haze", the resulting parameter "iHaze" obtains the dimension [length in nm].

$$iHaze = \int_{380\,nm}^{800\,nm} Haze(\lambda)\,d\lambda \qquad (2)$$

*Measuring devices:* The measurements were carried out using unpolarized light on a *Cary 5E* spectral photometer from *Varian* in a spectral range of 350 to 800 nm. In order to measure the diffusely transmitted component $T_{diffus}(\lambda)$, an Ulbricht globe ("integrating sphere") was available for this purpose (size of the measurement area: 10 x 10 mm).

In this case, the directed and unscattered component of the electromagnetic radiation transmitted with a perpendicular radiation incidence is passed out of the measurement globe and guided into a light trap. The scattered signal portion $T_{diffus}(\lambda)$ is picked up in a globe (diameter 110 mm) coated with PTFE (*polytetrafluoroethylene,* Lambert radiator) and measured by means of a photodiode protected in a globe from direct irradiation. It is greater the more the specimen scatters the light. On account of the multiple reflections of the light on the inside of the globe, there is the same wavelength-dependent radiation intensity at every point in the volume of the globe. Therefore, on account of the screen, the detector does not measure any direct signal of the specimen or of the directly illuminated globe surface (in the case of an enclosed light trap). If the light trap is covered with a thin barium sulfate layer, then, in addition to the diffuse portion, the directed portion $T_{spec}(\lambda)$ is also contained in the measured signal. The Haze is calculated in accordance with equation 1.

*Ellipsometry*

In order to determine the refractive index and layer thickness of the specimens, the measurement method of ellipsometry was used. The method is based on the change in the polarization state of a wave upon reflection on the specimen surface that is under examination. The change in the polarization state is described by the quotient p of the two complex Fresnel reflection coefficients $r_p$ and $r_s$. This can be shown by the relation

$$\rho = \frac{r_p}{r_s} = \tan \Psi \cdot e^{i\Delta} \qquad (3)$$

which is also referred to as the basic ellipsometric equation. Here, $\Psi$ represents the change in the amplitude ratio of the perpendicular and parallel component, and $\Delta$ measures the change in phase difference between the two part-waves as a result of the reflection. The subscripts s and p symbolize the part-waves that are polarized perpendicular and parallel to the plane of incidence, respectively. The refractive index was determined according to R.M.A. Azzam, N.M. Bashara, *Ellipsometry and polarized light,* North Holland, Amsterdam (1987).

If a suitable material model is then defined for the layer/substrate system, in which the properties (optical constants, layer thicknesses) of the material model are linked to the complex reflection coefficients and the measurement parameters (wavelength, angle of incidence), then precise statements can be made about a large number of important film parameters on the basis of the change in the polarization state. The dispersion of the optical constants of the specimens was described using a conventional parameterized Lorentz Oscillator model. This defines the oscillatory behavior of the electrons, which are elastically bound to the solid body atoms, in the event of excitation by means of electromagnetic radiation (see: A. Röseler, Infrared Spectroscopic Ellipsometry, Akademie-Verlag, Berlin (1990)). The specified refractive indices $n$ and $n_{550}$ relate to a wavelength of $\lambda$ = 550 nm and are given to an accuracy of $\pm 0.01$.

A spectrophotometric ex-situ *SE800* ellipsometer from *SENTECH Instruments* was available for the ellipsometric measurements, said ellipsometer operating in the so-called *PCSSA* configuration ("Polarizer Compensator Sample Step Scan Analyzer").

The evaluation was carried out in the spectral range of 380 to 850 nm and at variable angles of incidence of between 55 and 75° ($\Delta$ = 5°). Commercially available evaluation software from *SENTECH Instruments* ("*Advanced Fit*"), in which a numerical method is integrated in accordance with the simplex algorithm, was available for adapting the measured data to the model.

**Claims**

1. A transparent, thermally stable coating

   - comprising titanium oxide having a rutile structure,
   - having at a wavelength of 550 nm a refractive index of n = 2.65 to n = 2.75 and
   - being produced, at an oxygen partial pressure p which can be defined, by high ion bombardment sputtering at an initial deposition temperature of 100 to 200 °C from a titanium target with an ion sputtering power density of 9 - 15 W/cm$^2$ and especially preferably 11-12 W/cm$^2$.

2. A transparent coating as claimed in claim 1, **characterized in that** after annealing in a furnace at 800°C for 15 hours, the coating remains transparent and/or has a refractive index of n = 2.65 to n = 2.75.

3. A transparent coating as claimed in one of claims 1 and 2, **characterized in that** the coating having a rutile structure and a layer thickness of 400 nm, after annealing in a furnace at 800°C for 15 hours, remains transparent and has an iHaze of $\geq$ nm to 80 nm, preferably 20 nm to 70 nm, more preferably an iHaze of 30 nm to 60 nm and especially preferably an iHaze of 40 nm to 50 nm.

4. A transparent layer as claimed in one of claims 1 to 3, **characterized in that** the layer is substantially amorphous, preferably is amorphous, and has a rutile-like short-range order structure, with the layer preferably not having any anatase structure.

5. A multilayer interference filter for reflecting light within a wavelength range of the transparent spectrum of 250 nm to 5000 nm, preferably 350 to 2500 nm, more preferably 400 to 2000 nm and in particular 420 to 1500 nm, with the layer having one or more first layers and one or more second layers with a refractive index which is lower than that of the one or more first layers, said layers being arranged alternately on a substrate, preferably a transparent substrate, **characterized in that** the one or more first layers is/are designed as claimed in one of claims 1 to 4.

6. A multilayer interference filter as claimed in claim 5, **characterized in that**, at a wavelength of $\lambda$ = 550 nm, for the one or more second layers the refractive index is n = 1.32 to n = 2.0, preferably n = 1.35 to n = 1.80, more preferably n = 1.44 to n = 1.75.

7. A body having at least one transparent layer and/or multilayer interference filter as claimed in one of claims 1 to 6, **characterized in that** the body is selected from the group comprising beam-forming devices, beam-splitting devices, fiber-optic components, illumination means, in particular lamps, preferably suitable for use in motor vehicles, lamp housings, gas sensors, glasses, in particular insulation glazing, plastics, transparent elements, filters, lenses, mirrors, laser mirrors, in particular transparent filter systems, hot-light mirrors, cold-light mirrors, antireflection systems, band-pass filters, cut-off filters, low-e glazing and/or bodies for electrical applications, such as electrical components, in particular diffusion barriers and/or capacitor elements.

8. A method of producing a transparent, thermally stable, highly refractive coating comprising titanium oxide having a rutile structure, **characterized in that** the coating comprising titanium oxide is deposited, with the rutile structure being obtained, on the surface of the substrate that is to be coated, at an oxygen partial pressure p which can be defined, by high ion bombardment sputtering, at an initial deposition temperature of 100 to 200°C from a titanium target, wherein the ion sputtering power density is 9 - 15 W/cm$^2$ and especially preferably 11-12 W/cm$^2$.

9. A method as claimed in claim 8, **characterized in that** the oxygen partial pressure is p ≤ 100 mPa, in particular p ≤ 10 mPa, preferably 6 - 10 mPa and especially preferably ≤ 8 mPa.

10. A method as claimed in claims 8 or 9, **characterized in that**, in a manufacturing process, the layers produced are tested at least in a randomly sampled manner in terms of reproducibility of the structure and of the layer thickness by means of Raman spectroscopy and/or X-ray spectroscopy.

**Patentansprüche**

1. Transparente, thermisch stabile Beschichtung

    - mit Titanoxid mit einer Rutilstruktur,
    - die, bei einer Wellenlänge von 550 nm eine Brechzahl von n = 2,65 bis n = 2,75 hat und
    - die bei einem Sauerstoffpartialdruck p, die definiert werden kann, durch einen hohen Eisenerstäubungsbeschuss bei einer Anfangsablagerungstemperatur von 100 bis 200°C von einem Titanziel mit einer Eisenerstäubungsleistungsdichte von 9 - 15 W/cm$^2$ und insbesondere vorzugsweise 11 - 12 W/cm$^2$ hergestellt wird.

2. Transparente Beschichtung nach Anspruch 1, **dadurch gekennzeichnet, dass** nach der Glühbehandlung wahrend 15 Stunden in einem Ofen bei 800°C die Beschichtung nach wie vor transparent ist und/oder eine Brechzahl von n = 2,65 bis n = 2,75 hat.

3. Transparente Beschichtung nach Anspruch 1 und 2, **dadurch gekennzeichnet, dass** die Beschichtung eine Rutilstruktur hat und eine Schichtdicke von 400 nm, und zwar nach einer Glühbehandlung von 15 Stunden in einem Ofen bei 800°C nach wie vor transparent ist und eine "iHaze" ≥ 0 nm bis 80 nm, vorzugsweise 20 nm bis 70 nm und am liebsten eine "iHaze" von 30 nm bis 60 nm und am allerliebsten eine "iHaze" von 40 nm bis 50 nm hat.

4. Transparente Schicht nach Anspruch 1 bis 3, **dadurch gekennzeichnet, dass** die Schicht im Wesentlichen amorph, vorzugsweise amorph ist und eine rutilartige Struktur einer Kurzstreckenordnung hat, wobei die Schicht vorzugsweise überhaupt keine Anatasstruktur hat.

5. Mehrschichtinterferenzfilter zum Reflektieren von Licht innerhalb eines Wellenlängenbereichs des transparenten Spektrums von 250 nm bis 5000 nm, vorzugsweise 350 nm bis 2500 nm, lieber von 400 nm bis 2000 nm und am liebsten von 420 nm bis 1500 nm, wobei die Schicht eine oder mehrere erste Schichten und eine oder mehrere zweite Schichten mit einer Brechzahl hat, die niedriger ist als die der einen oder der mehreren ersten Schichten, wobei die genannten Schichten wechselweise auf einem Substrat, vorzugsweise einem transparenten Substrat, vorgesehen sind, **dadurch gekennzeichnet, dass** die eine erste Schicht oder mehrere erste Schichten wie in einem der Ansprüche 1 bis 4 beansprucht, entworfen ist bzw. sind.

6. Mehrschichtinterferenzfilter nach Anspruch 5, **dadurch gekennzeichnet, dass** bei einer Wellenlänge λ = 550 nm für die eine zweite Schicht oder mehrere zweite Schichten die Brechzahl n = 1,32 bis n = 2,0, vorzugsweise n = 1,35 bis n = 1,80 am liebsten n = 1,44 bis 1,75 beträgt.

7. Körper mit wenigstens einer transparenten Schicht und/oder einem Mehrschichtinterferenzfilter nach einem der vorstehenden Ansprüche 1 bis 6, **dadurch gekennzeichnet, dass** der Körper aus der Gruppe Strahlbildungsanordnungen, Strahlteilungsanordnungen, faseroptischer Bauteile, Beleuchtungsmittel, insbesondere Lampen, vorzugsweise geeignet zur Verwendung in Kraftfahrzeugen, Lampengehäuse, Gassensoren, Gläser, insbesondere Isolationsverglasung, Kunststoffe, transparente Elemente, Filter, Linsen, Spiegel, Laserspiegel, insbesondere transparente Filtersysteme, Heißlichtspiegel, Kaltlichtspiegel, Antireflexionssysteme, Bandpassfilter, Trennfilter, "low-e" Verglasung und/oder Körper für elektrische Anwendung, wie elektrische Bauteile, insbesondere Diffusionsbarrieren und/oder Kondensatorelemente.

8. Verfahren zum Herstellen einer transparenten, thermisch stabilen, äußerst lichtbrechenden Beschichtung mit Titanoxid mit einer Rutilstruktur, **dadurch gekennzeichnet, dass** die Beschichtung mit Titanoxid abgelagert wird, wobei die Rutilstruktur an der Oberfläche des zu beschichtenden Substrats erhalten wird, und zwar bei einem Sauerstoffpartialdruck p, die definiert werden kann, durch einen hohen Eisenzerstäubungsbeschuss bei einer Anfangsablagerungstemperatur von 100 bis 200°C von einem Titanziel mit einer Eisenzerstäubungsleistungsdichte von 9 - 15 W/cm$^2$ und insbesondere vorzugsweise 11-12 W/cm$^2$.

9. Verfahren nach Anspruch 8, **dadurch gekennzeichnet, dass** der Sauerstoffpartialdruck p < 100 mPa, insbesondere p ≤ 10 mPa, vorzugsweise 6-10 mPa und am liebsten ≤ 8 mPa beträgt.

10. Verfahren nach Anspruch 8 oder 9, **dadurch gekennzeichnet, dass** in einem Herstellungsprozess die erzeugten Schichten wenigstens stichprobenweise in Termen der Reproduzierbarkeit der Struktur und der Schichtdicke, und zwar mit Hilfe von Raman-Spektroskopie und/oder Röntgenspektroskopie getestet werden.

**Revendications**

1. Revêtement transparent thermiquement stable

   - comprenant de l'oxyde de titane qui présente une structure de rutile,
   - ayant, à une longueur d'onde égale à 550 nm, un indice de réfraction de n = 2,65 jusqu'à n = 2,75, et
   - étant produit, à une pression partielle p de l'oxygène qui peut être définie, par pulvérisation cathodique à haute intensité par bombardement ionique à une température de dépôt initiale dans la gamme comprise entre 100 °C et 200 °C à partir d'une cible de titane avec une densité de puissance de la pulvérisation ionique dans la gamme comprise entre 9 et 15 W/cm$^2$ et particulièrement de préférence dans la gamme comprise entre 11 et 12 W/cm$^2$.

2. Revêtement transparent selon la revendication 1, **caractérisé en ce que**, après recuit dans un four à 800 °C pendant 15 heures, le revêtement reste transparent et/ou présente un indice de réfraction de n = 2,65 jusqu'à n = 2,75.

3. Revêtement transparent selon l'une quelconque des revendications précédentes 1 à 2, **caractérisé en ce que** le revêtement ayant une structure de rutile et une épaisseur de couche égale à 400 nm, après recuit dans un four à 800 °C pendant 15 heures, reste transparent et présente un iHaze dans la gamme comprise entre ≥ 0 nm et 80 nm, de préférence dans la gamme comprise entre 20 nm et 70 nm, plus préférentiellement un iHaze dans la gamme comprise entre 30 nm et 60 nm et particulièrement de préférence un iHaze dans la gamme comprise entre 40 nm et 50 nm.

4. Couche transparente selon l'une quelconque des revendications précédentes 1 à 3, **caractérisée en ce que** la couche est sensiblement amorphe, de préférence est amorphe et présente une structure d'ordre à courte portée en forme de rutile, la couche n'ayant de préférence pas de structure anatase quelconque.

5. Filtre interférentiel multicouche pour réfléchir de la lumière dans une gamme de longueurs d'onde du spectre transparent de 250 nm jusqu'à 5000 nm, de préférence de 350 nm jusqu'à 2500 nm, plus préférentiellement de 400 nm jusqu'à 2000 nm et en particulier de 420 nm jusqu'à 1500 nm, la couche ayant une ou plusieurs premières couches et une ou plusieurs deuxièmes couches avec un indice de réfraction qui est inférieur à celui de l'une ou des plusieurs premières couches, lesdites couches étant déposées alternativement sur un substrat, de préférence un substrat transparent, **caractérisé en ce que** l'une ou les plusieurs premières couches est/sont conçue(s) selon l'une quelconque des revendications précédentes 1 à 4.

6. Filtre interférentiel multicouche selon la revendication 5, **caractérisé en ce que**, à une longueur d'onde de λ = 550 nm, pour l'une ou les plusieurs deuxièmes couches l'indice de réfraction est n = 1,32 jusqu'à n = 2,0, de préférence n = 1,35 jusqu'à n = 1,80, plus préférentiellement n = 1,44 jusqu'à n = 1,75.

7. Corps ayant au moins une couche transparente et/ou un filtre interférentiel multicouche selon l'une quelconque des revendications précédentes 1 à 6, **caractérisé en ce que** le corps est sélectionné parmi le groupe comprenant des dispositifs de formation de faisceau, des dispositifs de division de faisceau, des composants à fibre optique, des moyens d'éclairage, en particulier des lampes étant de préférence appropriées à être utilisées dans des véhicules à moteur, des boîtiers de lampe, des capteurs de gaz, des lunettes, en particulier du vitrage d'isolation, des plastiques, des éléments transparents, des filtres, des lentilles, des miroirs, des miroirs laser, en particulier des systèmes filtrants transparents, des miroirs à lumière chaude, des miroirs à lumière froide, des systèmes anti-réfléchissants, des filtres passe-bande, des filtres de coupure, du vitrage à faible émissivité et et/ou des corps pour des applications électriques, telles que des composants électriques, en particulier des barrières de diffusion et/ou des éléments de condensateur.

8. Procédé de production d'un revêtement transparent thermiquement stable de réfraction élevée comprenant de l'oxyde de titane ayant une structure de rutile, **caractérisé en ce que** le revêtement comprenant de l'oxyde de titane est déposé, la structure de rutile étant obtenue, sur la surface du substrat qui est à revêtir, à une pression partielle p de l'oxygène qui peut être définie, par pulvérisation cathodique à haute intensité par bombardement ionique à une température de dépôt initiale dans la gamme comprise entre 100 °C et 200 °C à partir d'une cible de titane où la densité de puissance de la pulvérisation ionique se situe dans la gamme comprise entre 9 et 15 W/cm$^2$ et particulièrement de préférence dans la gamme comprise entre 11 et 12 W/cm$^2$.

9. Procédé selon la revendication 8, **caractérisé en ce que** la pression partielle de l'oxygène est p ≤ 100 mPa, en particulier p ≤ 10 mPa, de préférence se situe dans la gamme comprise entre 6 mPa et 10 mPa et est particulièrement de préférence ≤ 8 mPa.

10. Procédé selon la revendication 8 ou selon la revendication 9, **caractérisé en ce que**, dans un processus de fabrication, les couches qui sont produites sont essayées au moins d'une manière aléatoirement échantillonnée en termes de reproductibilité de la structure et de l'épaisseur de couche à l'aide d'une spectroscopie Raman et/ou d'une spectroscopie à rayons X.

FIG.1

FIG.2a

FIG.2b

FIG.3a

FIG.3b

FIG.4

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **A. Röseler.** Infrared Spectroscopic Ellipsometry. Akademie-Verlag, 1990